# EUROPÄISCHE PATENTSCHRIFT

(11) **EP 2 598 975 B1**
(45) Veröffentlichungstag und Bekanntmachung des Hinweises auf die Patenterteilung: **07.06.2017**
(21) Anmeldenummer: 11733871.5
(22) Anmeldetag: 19.07.2011
(51) Int. Cl.: H03K 17/96, G01R 3/00, G01R 27/26

(54) **VERFAHREN ZUR HERSTELLUNG EINES KAPAZITIVEN BERÜHRUNGSSENSORS SOWIE KAPAZITIVER BERÜHRUNGSSENSOR**
METHOD FOR PRODUCING A CAPACITIVE CONTACT SENSOR AND CAPACITIVE CONTACT SENSOR
PROCÉDÉ DE FABRICATION D'UN DÉTECTEUR DE CONTACT CAPACITIF ET DÉTECTEUR DE CONTACT CAPACITIF

(30) Priorität: 30.07.2010 DE 102010032951
(43) Veröffentlichungstag der Anmeldung: 05.06.2013
(73) Patentinhaber: Continental Automotive GmbH, 30165 Hannover (DE)
(72) Erfinder: BOLTE, Peter, 35418 Buseck (DE); FIEGLER, Till, 35510 Butzbach / Maibach (DE)
(86) Internationale Anmeldenummer: PCT/EP2011/062367
(87) Internationale Veröffentlichungsnummer: WO 2012/013545

(56) Entgegenhaltungen:
- DE-A1- 4 336 820
- US-A1- 2007 031 161
- US-A1- 2010 013 499

## Beschreibung

Die Erfindung bezieht sich auf ein Verfahren zur Herstellung eines kapazitiven Berührungssensors mit einer aus Kunststoff bestehenden Trägerplatte, durch Berühren von deren Vorderfläche ein Schaltvorgang auslösbar ist und auf deren Rückfläche eine oder mehrere kapazitive Sensorelektroden angeordnet sind, die über Leiterbahnen mit einer Auswerteelektronik verbunden sind, wobei die den auf der Vorderfläche der Trägerplatte den Sensorelektroden gegenüberliegenden Bereiche Kontaktzonen bilden.

Bei derartigen kapazitiven Berührungssensoren ist es bekannt, die Trägerplatte durch Spritzgießen herzustellen, die Frontseite mit einer Lackierung zu versehen und auf die Rückseite die kapazitiven Sensorelektroden aufzukleben.

Die Herstellung dieser Berührungssensoren erfordert in aufwendiger Weise mehrere Füge- und Montageprozesse, um die einzelnen Bauteile miteinander zu verbinden.

Aus der US-A-2007/0031161 ist ein kapazitiver Berührungssensor der eingangs genannten Art bekannt, wobei eine Kunststofffolie auf einer Seite die Sensorelektroden und Leiterbahnen trägt und die Trägerplatte aus Polycarbonat besteht sowie auf die den Sensorelektroden gegenüberliegende Seite der Trägerplatte aufgespritzt ist.

Aus der DE-A-43 36 820 ist ein Verfahren zum Spritzguss-Kunststoffummanteln eines elektronischen Sensors wie eines Rauch-, Brand- oder Feuermelders bekannt. Die Ummantelung soll einen hermetischen Abschluss des Sensors gewährleisten, da ein Feuchtigkeitseintritt zum Sensor zu dessen Funktionsunfähigkeit führen kann. Der Sensor wird in einem ersten Schritt mit einem Rahmen umspritzt, um dann in einem zweiten Schritt mit der Ummantelung umspritzt zu werden. Dabei können die Kunststoffe für den Rahmen und die Ummantelung die gleichen sein und im zweiten Schritt der Kunststoff der Ummantelung den Kunststoff des Rahmens an der Oberfläche aufschmelzen.

Aus der US-A-2010/0013499 ist ein kapazitiver Berührungssensor bekannt, bei dem kapazitive Sensorelektroden auf der einer Bedienperson abgewandten Seite eines Plastikfilms angeordnet sind. Ein Laminat, eine Harzschicht und ein aufgespritzter Kunststoffträger sind weiterhin die Sensorelektroden auf der der Bedienperson abgewandten Seite abdeckend angeordnet.

Aufgabe der Erfindung ist es, ein Verfahren zur Herstellung eines kapazitiven Berührungssensors und einen kapazitiven Berührungssensor zu schaffen, wobei in einem einfachen Herstellungsprozess ein einfach aufgebauter Berührungssensor hoher Qualität erzeugt werden kann.

Diese Aufgabe wird erfindungsgemäß dadurch gelöst, dass eine die Sensorelektroden und Leiterbahnen tragende Kunststofffolie auf eine erste Seitenwand einer Kavität eines Spritzgießwerkzeugs mit den Sensorelektroden zur ersten Seitenwand gerichtet eingelegt und dann auf der den Sensorelektroden abgewandten Seite der Kunststofffolie ein die Trägerplatte bildendes Polycarbonat (PC) in die Kavität eingespritzt wird, dass dann das aus Kunststofffolie und Trägerplatte bestehende Bauteil aus der Kavität entnommen und in eine zweite Kavität eingelegt wird, wobei dann in der zweiten Kavität auf der der Kunststofffolie abgewandten Seite ein Spalt gebildet ist, der mit einem eine kratzfeste Beschichtung bildenden, mit dem Polycarbonat im Berührungsbereich reagierenden weiteren Kunststoff ausgespritzt wird.

Eine weitere Lösung der Aufgabe besteht darin, dass eine die Sensorelektroden und Leiterbahnen tragende Kunststofffolie auf eine erste Seitenwand einer Kavität eines Spritzgießwerkzeugs mit den Sensorelektroden zur ersten Seitenwand gerichtet eingelegt wird, wobei die Kunststofffolie auf ihrer den Sensorelektroden abgewandten Seite mit einer Haftvermittlerschicht versehen ist und dass dann auf der den Sensorelektroden abgewandten Seite der Kunststofffolie ein die Trägerplatte bildendes Polymethylmethacrylat (PMMA) in die Kavität eingespritzt wird, dass dann das aus Kunststofffolie und Trägerplatte bestehende Bauteil aus der Kavität entnommen und in eine zweite Kavität eingelegt wird, wobei dann in der zweiten Kavität auf der der Kunststoffolie abgewandten Seite ein Spalt gebildet ist, der mit einem eine kratzfeste Beschichtung bildenden, mit dem Polymethylmethacrylat der Trägerplatte im Berührungsbereich stoffschlüssig verbindenden weiteren Kunststoff ausgespritzt wird.

Durch das Aufspritzen der Trägerplatte auf die Kunststofffolie erfolgt gleichzeitig ohne separaten Montagevorgang ein Verbinden der Sensorelektroden mit der Trägerplatte.

Die Kunststofffolie bildet nicht nur einen einfach handhabbaren Träger für die exakte Platzierung der Sensorelektroden in der Kavität, sondern schützt in Doppelfunktion die Sensorelektroden vor einer Beschädigung und Verschiebung ihrer Position in der Kavität durch den mit hohem Druck in die Kavität eingespritzten Kunststoff der Trägerplatte.

In der einen Ausführungsform erfolgt ohne ein Entnehmen der Trägerplatte aus der Kavität, nur durch deren Erweiterung und Ausspritzen das Auftragen der kratzfesten Beschichtung.

Die hohe Warmformstabilität des Kunststoffs der Trägerplatte führt zu einer hohen Maßhaltigkeit des Berührungssensors, da weitestgehend kein Verziehen auftritt. Eine Nachbearbeitung kann somit entfallen.

Gleichzeitig splittert die aus PC bestehende Trägerplatte nicht, so dass der Berührungssensor als Bedienblende selbst im Kopfaufprallbereich im Kraftfahrzeug benutzt werden kann.

Bei der aus PMMA bestehenden Trägerplatte hat es sich überraschenderweise gezeigt, dass sich durch die Haftvermittlerschicht die an sich schlechten Brucheigenschaften des PMMA signifikant verbessern, so dass auch in diesem Fall der Berührungssensor als Bedienblende selbst im Kopfaufprallbereich im Kraftfahrzeug benutzt werden kann.

Da ein separates Handling von Teilen zwischen einzelnen Herstellungsschritten entfällt, wird auch ein Risiko einer Verschmutzung und einer Beschädigung der Bauteile durch Transport und Zwischenlagerung minimiert, was eine Qualitätssteigerung bedeutet.

Zu einer guten Verbindung von Kunststofffolie und Trägerplatte kommt es, wenn die Kunststofffolie eine Polycarbonatfolie ist.

Ist der die kratzfeste Beschichtung bildende weitere Kunststoff ein Polymethylmethacrylat (PMMA), so weist sie über die Kratzfestigkeit hinaus auch Chemikalienbeständigkeit auf.

Durch das Reagieren des PMMA mit dem Polycabonat mittels eines Reaktivsystems analog eines 2-Komponenten-Klebstoffs kommt es nach der Reaktion zu einer quasi ein Duroplast bildenden festen Verbindung zwischen diesen beiden Werkstoffen.

Wenn die der ersten Seitenwand der Kavität gegenüberliegende zweite Seitenwand der Kavität ganz oder bereichsweise mit einer Oberflächenstruktur versehen ist, kann ohne jeden Mehraufwand die Betätigungsfläche des Berührungssensors mit einer entsprechenden Oberflächenstruktur versehen werden.

Dadurch können ohne speziellen Aufwand z. B. ein die Betätigungsfläche ganz überdeckender Glanzgrad oder partiell unterschiedliche Glanzgrade der Betätigungsfläche erzeugt werden.

Dazu kann die Oberflächenstruktur eine Erodierstruktur oder eine Ätzstruktur sein.

Es ist aber auch möglich, dass die Oberflächenstruktur eine Nanostruktur mit Ausstülpungen kleiner als die Wellenlänge des Lichts ist.

Dies führt auf einfache Weise mit dem Herstellungsvorgang der Trägerplatte zu einer Reflexe mindernden Oberfläche, die darüber hinaus eine leichtere Reinigbarkeit ("easy to clean") oder sogar eine geringere Sichtbarkeit von Fingerabdrücken ("antifingerprint") erzeugen kann.

Weist die der ersten Seitenwand der Kavität gegenüberliegende zweite Seitenwand der Kavität eine oder mehrere vertiefte oder erhöhte Bereiche auf, so können Erhöhungen und Vertiefungen an der Betätigungsfläche des Berührungssensors erzeugt werden, die als Fühlhilfen und haptische Elemente dienen können.

Eine Vertiefung, eine Erhöhung oder ein durch Erhöhungen umschlossener Bereich kann der Bereich einer Kontaktzone sein.

Die Kunststofffolie kann eine transparente Kunststofffolie sein, so dass der Berührungssensor transmissiv durchleuchtbar ist.

Der Berührungssensor erhält dekorative Eigenschaften, wenn die Kunststofffolie und/oder die Trägerplatte farbig sind.

Weiterhin können auf der der ersten Seitenwand zugewandten Seite der Kunststofffolie Zeichen und/oder Symbole und/oder Ornamente angeordnet sein und die Trägerplatte durch ein transparentes PC erzeugt sein.

Durch die Kunststofffolie werden die Zeichen, Symbole und Ornamente, die aufgedruckt sein können, gegen ein Verwaschen und Beschädigen durch den Kunststoff der Trägerplatte bei dessen Einspritzen in die Kavität geschützt.

Ein Durchleuchten des Berührungssensors wird nicht beeinträchtigt, wenn die Sensorelektroden transparente Sensorelektroden sind.

Eine räumliche Gestaltungsfreiheit ohne Mehraufwand wird erhalten, wenn die erste Seitenwand und/oder die zweite Seitenwand der Kavität eine räumlich gekrümmte Form und/oder von einer Ebene räumlich abweichende Bereiche aufweist.

Dabei ist vorzugsweise die Kunststofffolie eine tiefgezogene Kunststofffolie mit einer der ersten Seitenwand angepassten Form.

Die Vorteile der Merkmale der Ansprüche 1 bis 13 treffen entsprechend auch auf den kapazitiven Berührungssensor mit den Merkmalen der Ansprüche 14 bis 19 zu.

Ist auf der die Sensorelektroden und Leiterbahnen tragenden Seite der Kunststofffolie eine Auswerteelektronik angeordnet, so erfüllt die Kunststofffolie neben den bereits genannten Funktionen noch die Funktion als Trägerbauteil für die Auswerteelektronik.

Ausführungsbeispiele der Erfindung sind in der Zeichnung dargestellt und werden im Folgenden näher beschrieben. Es zeigen:
- Figur 1: eine perspektivische Vorderansicht eines ersten Ausführungsbeispiels eines kapazitiven Berührungssensors,
- Figur 2: einen Längsschnitt durch den Berührungssensor nach Figur 1,
- Figur 3: einen vergrößerten Ausschnitt des Berührungssensors nach Figur 1,
- Figur 4: eine perspektivische Untenansicht des Berührungssensors nach Figur 1,
- Figur 5: einen Längsschnitt einer perspektivischen Vorderansicht eines zweiten Ausführungsbeispiels eines kapazitiven Berührungssensors,
- Figur 6: einen vergrößerten Ausschnitt des Berührungssensors nach Figur 5,
- Figur 7: eine perspektivische Untenansicht des Berührungssensors nach Figur 5,
- Figur 8: eine perspektivische Vorderansicht eines dritten Ausführungsbeispiels eines kapazitiven Berührungssensors,
- Figur 9: einen vergrößerten Ausschnitt einer perspektivischen Seitenansicht eines vierten Ausführungsbeispiels eines kapazitiven Berührungssensors,
- Figur 10: eine perspektivische Vorderansicht eines fünften Ausführungsbeispiels eines kapazitiven Berührungssensors,
- Figur 11: eine perspektivische Vorderansicht eines sechsten Ausführungsbeispiels eines kapazitiven Berührungssensors,
- Figur 12: eine perspektivische Untenansicht des Berührungssensors nach Figur 11,
- Figur 13: einen ersten vergrößerten Ausschnitt aus Figur 11,
- Figur 14: einen zweiten vergrößerten Ausschnitt aus Figur 11.

Die in den Figuren dargestellten kapazitiven Berührungssensoren besitzen eine Kunststofffolie 1 aus transparentem Polycarbonat (PC), auf deren Unterseite nicht dargestellte kapazitive Sensorelektroden aufgebracht sind.

Auf die den Sensorelektroden abgewandte Oberseite der Kunststofffolie 1 ist eine Platte 2 aus einem transparenten oder opaken Polycarbonat (PC) in einem Spritzgussverfahren aufgespritzt.

Auf die der Kunststofffolie 1 gegenüberliegende Seite ist auf das Polycarbonat (PC) der Platte 2 eine transparente kratzfeste Beschichtung 3 aus Polymethylmethacrylat (PMMA) aufgespritzt, das mit dem Polycarbonat reagiert und eine Dicke etwa zwischen 15 µm und 280 µm besitzt.

Platte 2 und Beschichtung 3 bilden eine Trägerplatte 4, 4', 4'', 4'", 4"".

Entsprechend den Sensorelektroden sind auf der Vorderfläche 7 der Trägerplatte 2 Kontaktzonen 5, 5', 5" als sensitive Bereiche ausgebildet.

Eine Schaltfunktion wird dadurch ausgelöst, dass ein ausreichend großer leitfähiger Körper, beispielsweise ein menschlicher Finger in die Nähe einer Kontaktzone 5, 5', 5" und somit in die Nähe der der Kontaktzone 5, 5', 5" zugeordneten Sensorelektrode gebracht wird.

Das erzeugte Schaltsignal wird über nicht dargestellte auf der Kunststofffolie 1 angeordnete Leiterbahnen einer Auswerteelektronik zugeleitet.

Dazu erstreckt sich die Kunststofffolie 1 mit einer flexiblen Anbindung 6 über die Trägerplatte 4, 4', 4", 4"', 4"" hinaus und führt zu einer nicht dargestellten, die Auswerteelektronik tragenden Leiterplatte.

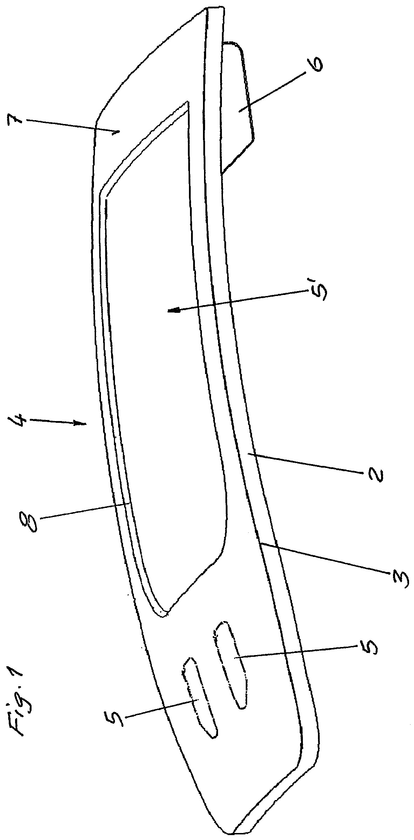

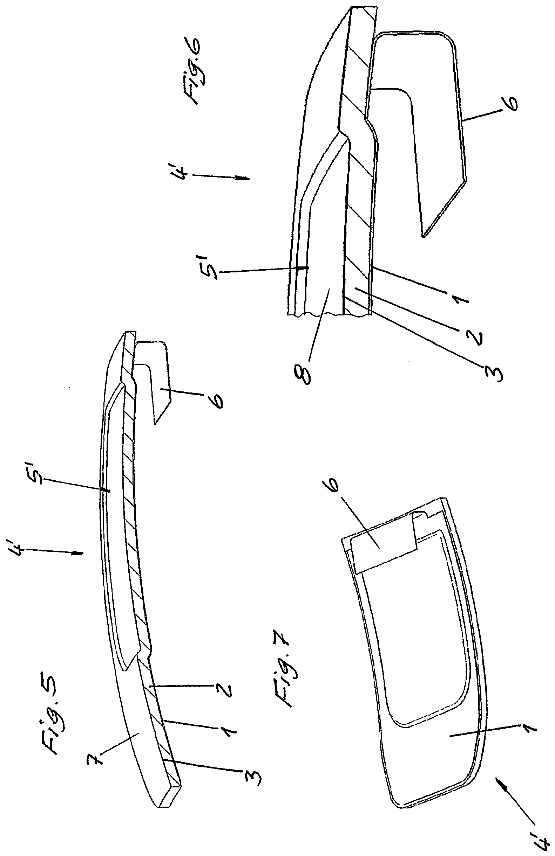

Bei den Ausführungsbeispielen der Figuren 1 bis 7 sind sowohl Kontaktzonen 5 mit ebener Vorderfläche 7 der Trägerplatte 4 als auch als Vertiefungen 8 an der Vorderfläche 7 ausgebildete Kontaktzonen 5' vorhanden.

In den Figuren 1 bis 3 besitzt die Trägerplatte 4 abgesehen von der Vertiefung 8 konstante Dicke.

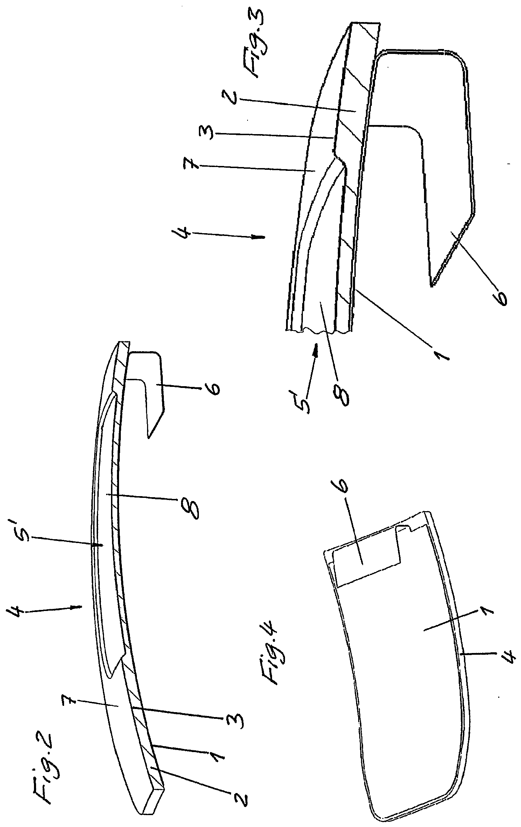

In den Figuren 4 bis 7 ist die Trägerplatte 4' und die Kunststofffolie 1 der Vertiefung 8 angepasst, so dass die Trägerplatte 4' ohne Ausnahme eine konstante Dicke besitzt.

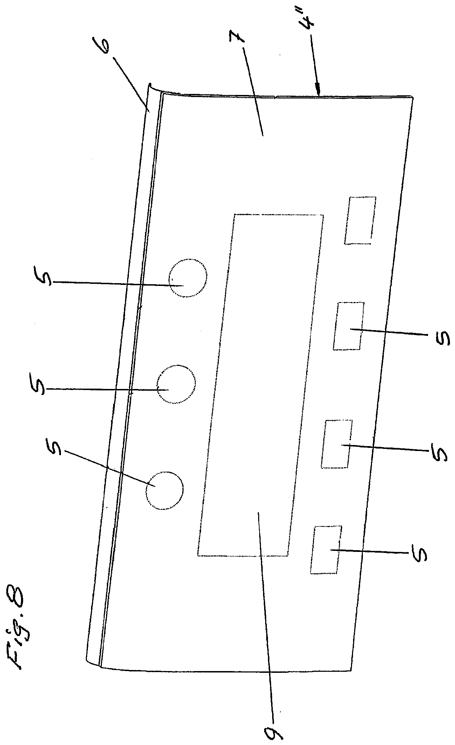

Das Ausführungsbeispiel der Figur 8 besitzt eine Trägerplatte 4" mit ebener Vorderfläche 7, auf der mit dünner Linie zwei Reihen mit Kontaktzonen 5 dargestellt sind.

Zwischen den beiden Reihen mit Kontaktzonen 5 ist ebenfalls mit dünner Linie ein Displaybereich 9 gekennzeichnet.

Da die Kunststofffolie 1 und die Trägerplatte 4" transparent sind, können entweder auf der Kunststofffolie 1 aufgedruckte Symbole, Zeichen und Ornamente auf der Vorderseite des Berührungssensors gesehen werden, der transmissiv durchleuchtbar sein kann.

Es ist aber auch möglich, ein Display im Displaybereich hinter der Trägerplatte 4" anzuordnen, das insbesondere ein transmissiv durchleuchtbares Display ist.

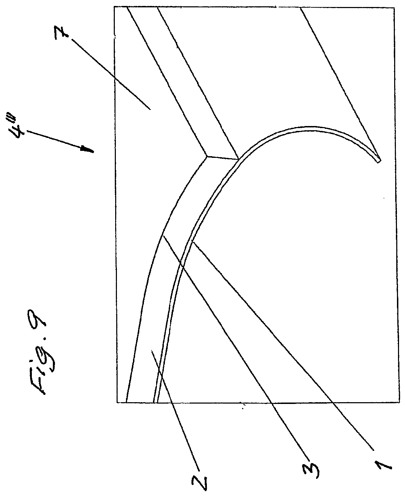

Bei dem in Figur 9 dargestellten Ausführungsbeispiel ist die Beschichtung 3 der Trägerplatte 4"' an der Vorderfläche 7 mit einer Nanostruktur versehen, die in der Darstellung aufgrund der Feinheit der Struktur nicht darstellbar ist.

Diese Nanostruktur dient zur Reflexminderung und gegebenenfalls sogar zur Anti-Fingerprint-Eigenschaft der Vorderfläche 7.

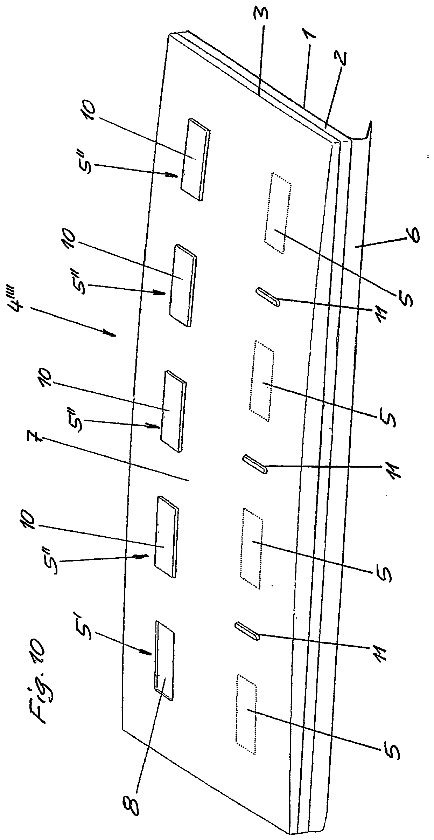

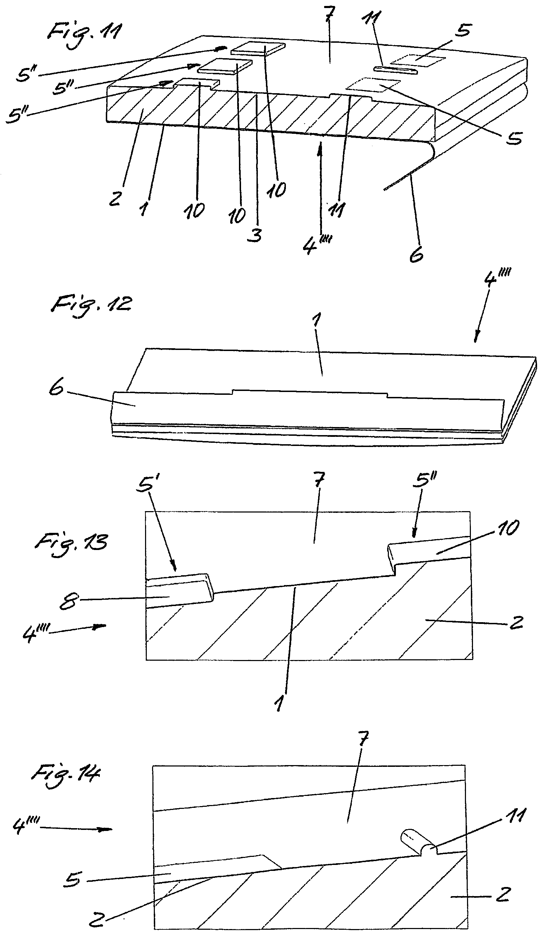

Das Ausführungsbeispiel der Figuren 10 bis 14 zeigt eine Trägerplatte 4"", die in der Vorderfläche 7 eine Vertiefung 8 bei einer Kontaktzone 5', eine Reihe Kontaktzonen 5 mit ebener Vorderfläche 7 sowie eine weitere Reihe mit tastenartigen Erhebungen 10 im Bereich von Kontaktzonen 5" aufweist.

Zwischen den Kontaktzonen 5 mit ebener Vorderfläche 7 sind als Fühlhilfen erhabene Trennwülste 11 von der Vorderfläche 7 hervorstehend ausgebildet.

## Patentansprüche

1. Verfahren zur Herstellung eines kapazitiven Berührungssensors mit einer aus Kunststoff bestehenden Trägerplatte, durch Berühren von deren Vorderfläche ein Schaltvorgang auslösbar ist und auf deren Rückfläche eine oder mehrere kapazitive Sensorelektroden angeordnet sind, die über Leiterbahnen mit einer Auswerteelektronik verbunden sind, wobei die den auf der Vorderfläche der Trägerplatte den Sensorelektroden gegenüberliegenden Bereiche Kontaktzonen bilden, **dadurch gekennzeichnet, dass** eine die Sensorelektroden und Leiterbahnen tragende Kunststofffolie (1) auf eine erste Seitenwand einer Kavität eines Spritzgießwerkzeugs mit den Sensorelektroden zur ersten Seitenwand gerichtet eingelegt und dann auf der den Sensorelektroden abgewandten Seite der Kunststofffolie (1) ein die Trägerplatte (4, 4', 4'', 4"', 4"") bildendes Polycarbonat in die Kavität eingespritzt wird, dass dann das aus Kunststofffolie und Trägerplatte bestehende Bauteil aus der Kavität entnommen und in eine zweite Kavität eingelegt wird, wobei dann in der zweiten Kavität auf der der Kunststofffolie abgewandten Seite ein Spalt gebildet ist, der mit einem eine kratzfeste Beschichtung bildenden, mit dem Polycarbonat im Berührungsbereich reagierenden weiteren Kunststoff ausgespritzt wird.

2. Verfahren zur Herstellung eines kapazitiven Berührungssensors mit einer aus Kunststoff bestehenden Trägerplatte, durch Berühren von deren Vorderfläche ein Schaltvorgang auslösbar ist und auf deren Rückfläche eine oder mehrere kapazitive Sensorelektroden angeordnet sind, die über Leiterbahnen mit einer Auswerteelektronik verbunden sind, wobei die den auf der Vorderfläche der Trägerplatte den Sensorelektroden gegenüberliegenden Bereiche Kontaktzonen bilden, **dadurch gekennzeichnet, dass** eine die Sensorelektroden und Leiterbahnen tragende Kunststofffolie auf eine erste Seitenwand einer Kavität eines Spritzgießwerkzeugs mit den Sensorelektroden zur ersten Seitenwand gerichtet eingelegt wird, wobei die Kunststofffolie auf ihrer den Sensorelektroden abgewandten Seite mit einer Haftvermittlerschicht versehen ist und dass dann auf der den Sensorelektroden abgewandten Seite der Kunststofffolie ein die Trägerplatte bildendes Polymethylmethacrylat in die Kavität eingespritzt wird, dass dann das aus Kunststofffolie und Trägerplatte bestehende Bauteil aus der Kavität entnommen und in eine zweite Kavität eingelegt wird, wobei dann in der zweiten Kavität auf der der Kunststoffolie abgewandten Seite ein Spalt gebildet ist, der mit einem eine kratzfeste Beschichtung bildenden, mit dem Polymethylmethacrylat der Trägerplatte im Berührungsbereich stoffschlüssig verbindenden weiteren Kunststoff ausgespritzt wird.

3. Verfahren nach einem der vorhergehenden Ansprüche, **dadurch gekennzeichnet, dass** die Kunststofffolie (1) eine Polycarbonatfolie ist.

4. Verfahren nach einem der vorhergehenden Ansprüche, **dadurch gekennzeichet**, dass der die kratzfeste Beschichtung (3) bildende weitere Kunststoff ein Polymethylmethacrylat ist.

5. Verfahren nach einem der vorhergehenden Ansprüche, **dadurch gekennzeichnet, dass** die der ersten Seitenwand der Kavität gegenüberliegende zweite Seitenwand der Kavität ganz oder bereichsweise mit einer Oberflächenstruktur versehen ist.

6. Verfahren nach Anspruch 5 **dadurch gekennzeichnet, dass** die Oberflächenstruktur eine Erodierstruktur oder eine Ätzstruktur ist.

7. Verfahren nach Anspruch 5, **dadurch gekennzeichnet, dass** die Oberflächenstruktur eine Nanostruktur mit Ausstülpungen kleiner als die Wellenlänge des Lichts ist.

8. Verfahren nach einem der vorhergehenden Ansprüche, **dadurch gekennzeichnet, dass** die der ersten Seitenwand der Kavität gegenüberliegende zweite Seitenwand der Kavität eine oder mehrere vertiefte Bereiche aufweist.

9. Verfahren nach einem der vorhergehenden Ansprüche, **dadurch gekennzeichnet, dass** die Kunststoffolie (1) eine transparente Kunststoffolie ist.

10. Verfahren nach den Ansprüchen 1 und 9, **dadurch gekennzeichnet, dass** auf der der ersten Seitenwand zugewandten Seite der Kunststofffolie (1) Zeichen und/oder Symbole und/oder Ornamente angeordnet sind und die Trägerplatte (4, 4', 4", 4'", 4"") durch ein transparentes Polycarbonat erzeugt ist.

11. Verfahren nach einem der Ansprüche 9 oder 10, **dadurch gekennzeichnet, dass** die Sensorelektroden transparente Sensorelektroden sind.

12. Verfahren nach einem der vorhergehenden Ansprüche, **dadurch gekennzeichnet, dass** die erste Seitenwand und/oder die zweite Seitenwand der Kavität eine räumlich gekrümmte Form und/oder von einer Ebene räumlich abweichende Bereiche aufweist.

13. Verfahren nach Anspruch 12, **dadurch gekennzeichnet, dass** die Kunststofffolie (1) eine tiefgezogene Kunststofffolie mit einer der ersten Seitenwand angepassten Form ist.

14. Kapazitiver Berührungssensor mit einer aus Kunststoff bestehenden Trägerplatte, durch Berühren von deren Vorderfläche ein Schaltvorgang auslösbar ist und auf deren Rückfläche eine oder mehrere kapazitive Sensorelektroden angeordnet sind, die über Leiterbahnen mit einer Auswerteelektronik verbunden sind, wobei die den auf der Vorderfläche der Trägerplatte den Sensorelektroden gegenüberliegenden Bereiche Kontaktzonen bilden, **dadurch gekennzeichnet, dass** eine Kunststofffolie (1) auf ihrer einen Seite die Sensorelektroden und Leiterbahnen trägt und die aus Polycarbonat oder aus Polymethylmethacrylat bestehende Trägerplatte (4, 4', 4", 4'", 4"") auf ihre andere Seite aufgespritzt ist, wobei auf die der Kunststoffolie (1) abgewandte Seite der Trägerplatte (4, 4', 4", 4'", 4"") eine kratzfeste Beschichtung (3) aufgespritzt ist, deren Werkstoff mit dem Polycarbonat reagiert oder mit dem Polymethylmethacrylat der Trägerplatte sich stoffschlüssig verbindet.

15. Kapazitiver Berührungssensor nach Anspruch 14, **dadurch gekennzeichnet, dass** die Kunststofffolie (1) aus Polycarbonat besteht.

16. Kapazitiver Berührungssensor nach einem der Ansprüche 14 oder 15, **dadurch gekennzeichnet, dass** die kratzfeste Beschichtung (3) aus einem Polymethylmethacrylat (PMMA) besteht.

17. Kapazitiver Berührungssensor nach einem der Ansprüche 14 bis 16, **dadurch gekennzeichnet, dass** die kratzfeste Beschichtung (3) auf der der Kunststofffolie (1) abgewandten Seite der Trägerplatte (4"') eine Oberflächenstruktur aufweist.

18. Kapazitiver Berührungssensor nach einem der Ansprüche 14 bis 17, **dadurch gekennzeichet**, dass die der Kunststofffolie (1) abgewandte Seite der Trägerplatte eine oder mehrere Erhebungen (10, 11) und/oder Vertiefungen (8) aufweist.

19. Kapazitiver Berührungssensor nach einem der Ansprüche 14 bis 18, **dadurch gekennzeichet**, dass auf der die Sensorelektroden und Leiterbahnen tragenden Seite der Kunststoffolie eine Auswerteelektronik angeordnet ist.

## Claims

1. Method for producing a capacitive contact sensor having a carrier plate consisting of plastic, a switching process being initiatable by touching the front surface thereof, and one or more capacitive sensor electrodes which are connected via conductor tracks to evaluation electronics being arranged on its rear surface, the regions on the front surface of the carrier plate which lie opposite the sensor electrodes forming contact zones, **characterized in that** a plastic film (1) carrying the sensor electrodes and conductor tracks is placed onto a first side wall of a cavity of an injection moulding tool with the sensor electrodes directed toward the first side wall, and then a polycarbonate forming the carrier plate (4, 4', 4", 4"', 4"") is injected into the cavity on the side of the plastic film (1) facing away from the sensor electrodes, **in that** the component consisting of the plastic film and the carrier plate is then removed from the cavity and placed into a second cavity, a gap then being formed in the second cavity on the side facing away from the plastic film, which gap is injected with a further plastic which reacts with the polycarbonate in the contact region and forms a scratchproof coating.

2. Method for producing a capacitive contact sensor having a carrier plate consisting of plastic, a switching process being initiatable by touching the front surface thereof, and one or more capacitive sensor electrodes which are connected via conductor tracks to evaluation electronics being arranged on its rear surface, the regions on the front surface of the carrier plate which lie opposite the sensor electrodes forming contact zones, **characterized in that** a plastic film carrying the sensor electrodes and conductor tracks is placed onto a first side wall of a cavity of an injection moulding tool with the sensor electrodes directed toward the first side wall, the plastic film being provided with an adhesion promoter layer on its side facing away from the sensor electrodes and **in that** a polymethyl methacrylate forming the carrier plate is then injected into the cavity on the side of the plastic film facing away from the sensor electrodes, **in that** the component consisting of the plastic film and the carrier plate is then removed from the cavity and placed into a second cavity, a gap then being formed in the second cavity on the side facing away from the plastic film, which is injected with a further plastic which connects with a material fit to the polymethyl methacrylate of the carrier plate in the contact region and forms a scratchproof coating.

3. Method according to one of the preceding claims, **characterized in that** the plastic film (1) is a polycarbonate film.

4. Method according to one of the preceding claims, **characterized in that** the further plastic which forms the scratchproof coating (3) is a polymethyl methacrylate.

5. Method according to one of the preceding claims, **characterized in that** the second side wall of the cavity, lying opposite the first side wall of the cavity, is fully or locally provided with a surface structure.

6. Method according to Claim 5, **characterized in that** the surface structure is an eroded structure or an etched structure.

7. Method according to Claim 5, **characterized in that** the surface structure is a nanostructure comprising protrusions smaller than the wavelength of light.

8. Method according to one of the preceding claims, **characterized in that** the second side wall of the cavity, lying opposite the first side wall of the cavity, comprises one or more depressed regions.

9. Method according to one of the preceding claims, **characterized in that** the plastic film (1) is a transparent plastic film.

10. Method according to Claims 1 and 9, **characterized in that** signs and/or symbols and/or ornaments are arranged on the side of the plastic film (1) facing the first side wall, and the carrier plate (4, 4', 4", 4"', 4"") is produced by a transparent polycarbonate.

11. Method according to one of Claims 9 and 10, **characterized in that** the sensor electrodes are transparent sensor electrodes.

12. Method according to one of the preceding claims, **characterized in that** the first side wall and/or the second side wall of the cavity has a spatially curved shape and/or regions spatially deviating from a plane.

13. Method according to Claim 12, **characterized in that** the plastic film (1) is a deep-drawn plastic film having a shape adapted to the first side wall.

14. Capacitive contact sensor having a carrier plate consisting of plastic, a switching process being initiatable by touching the front surface thereof, and one or more capacitive sensor electrodes which are connected via conductor tracks to evaluation electronics being arranged on its rear surface, the regions on the front surface of the carrier plate which lie opposite the sensor electrodes forming contact zones, **characterized in that** a plastic film (1) carries the sensor electrodes and conductor tracks on one of its sides and the carrier plate (4, 4', 4", 4"', 4"") consisting of polycarbonate or polymethyl methacrylate is injected onto its other side, a scratchproof coating (3), the material of which reacts with the polycarbonate or connects with a material fit to the polymethyl methacrylate of the carrier plate, being injected onto the side of the carrier plate (4, 4', 4", 4"', 4"") facing away from the plastic film (1).

15. Capacitive contact sensor according to Claim 14, **characterized in that** the plastic film (1) consists of polycarbonate.

16. Capacitive contact sensor according to one of Claims 14 and 15, **characterized in that** the scratchproof coating (3) consists of a polymethyl methacrylate (PMMA).

17. Capacitive contact sensor according to one of Claims 14 to 16, **characterized in that** the scratchproof coating (3) comprises a surface structure on the side of the carrier plate (4"') facing away from the plastic film (1).

18. Capacitive contact sensor according to one of Claims 14 to 17, **characterized in that** the side of the carrier plate facing away from the plastic film (1) comprises one or more elevations (10, 11) and/or depressions (8).

19. Capacitive contact sensor according to one of Claims 14 to 18, **characterized in that** evaluation electronics are arranged on the side of the plastic film carrying the sensor electrodes and conductor tracks.

## Revendications

1. Procédé de fabrication d'un capteur de contact capacitif comportant une plaque de support constituée de matière plastique, permettant de déclencher une opération de commutation par contact avec sa surface frontale et sur la surface arrière de laquelle sont disposées une ou plusieurs électrodes de capteur capacitives qui sont reliées par des pistes conductrices à une électronique d'évaluation, dans lequel les zones disposées en face des électrodes de capteur sur la surface frontale de la plaque de support forment des zones de contact, **caractérisé en ce qu'**un film de matière plastique (1) portant les électrodes de capteur et les pistes conductrices est déposé sur une première paroi latérale d'une cavité d'un outil de moulage par injection de manière à ce que les électrodes de capteur soient dirigées vers la première paroi latérale, puis **en ce qu'**un polycarbonate formant la plaque de support (4, 4', 4", 4'", 4"") est injecté dans la cavité sur la face du film en matière plastique (1) qui est opposée aux électrodes de capteur, et **en ce que** le composant constitué d'un film de matière plastique et d'une plaque de support est enlevé de la cavité et est déposé dans une deuxième cavité, dans lequel un interstice est ensuite formé dans la deuxième cavité sur la face qui est opposée au film de matière plastique, lequel interstice est rempli par injection avec une autre matière plastique formant un revêtement résistant aux rayures et réagissant avec le polycarbonate dans la zone de contact.

2. Procédé de fabrication d'un capteur de contact capacitif comportant une plaque de support constituée de matière plastique, permettant de déclencher une opération de commutation par contact avec sa surface frontale et sur la surface arrière de laquelle sont disposées une ou plusieurs électrodes de capteur capacitives qui sont reliées par des pistes conductrices à une électronique d'évaluation, dans lequel les zones disposées en face des électrodes de capteur sur la surface frontale de la plaque de support forment des zones de contact, **caractérisé en ce qu'**un film de matière plastique portant les électrodes de capteur et des pistes conductrices est déposé sur une première paroi latérale d'une cavité d'un outil de moulage par injection de manière à ce que les électrodes de capteur soient dirigées vers la première paroi latérale, dans lequel le film de matière plastique est pourvu d'une couche d'adhésif sur sa face qui est opposée aux électrodes de capteur, et **en ce qu'**un polyméthacrylate de méthyle formant la plaque de support est injecté dans la cavité sur la face du film de matière plastique qui est opposée aux électrodes de capteur, **en ce que** le composant constitué d'un film de matière plastique et d'une plaque de support est ensuite enlevé de la cavité et déposé dans une deuxième cavité, dans lequel un interstice est ensuite formé dans la deuxième cavité sur la face qui est opposée au film de matière plastique, lequel interstice est rempli par injection avec une autre matière plastique formant un revêtement résistant aux rayures et se liant par complémentarité de matériau au polyméthacrylate de méthyle de la plaque de support dans la zone de contact.

3. Procédé selon l'une quelconque des revendications précédentes, **caractérisé en ce que** le film de matière plastique (1) est un film de polycarbonate.

4. Procédé selon l'une quelconque des revendications précédentes, **caractérisé en ce que** l'autre matière plastique formant le revêtement (3) résistant aux rayures est un polyméthacrylate de méthyle.

5. Procédé selon l'une quelconque des revendications précédentes, **caractérisé en ce que** la deuxième paroi latérale de la cavité qui est en face de la première paroi latérale de la cavité est pourvue, entièrement ou par zones, d'une structure de surface.

6. Procédé selon la revendication 5, **caractérisé en ce que** la structure de surface est une structure d'érosion ou une structure de gravure.

7. Procédé selon la revendication 5, **caractérisé en ce que** la structure de surface est une nanostructure présentant des protubérances plus petites à la longueur d'onde de la lumière.

8. Procédé selon l'une quelconque des revendications précédentes, **caractérisé en ce que** la deuxième paroi latérale de la cavité qui est en face de la première paroi de la cavité présente une ou plusieurs zones renfoncées.

9. Procédé selon l'une quelconque des revendications précédentes, **caractérisé en ce que** le film de matière plastique (1) est un film de matière plastique transparent.

10. Procédé selon les revendications 1 et 9, **caractérisé en ce que** des signes et/ou des symboles et/ou des ornements sont disposés sur la face du film de matière plastique (1) qui est tournée vers la première paroi latérale, et **en ce que** la plaque de support (4, 4', 4", 4"', 4"") est produite par un polycarbonate transparent.

11. Procédé selon l'une quelconque des revendications 9 ou 10, **caractérisé en ce que** les électrodes de capteur sont des électrodes de capteur transparentes.

12. Procédé selon l'une quelconque des revendications précédentes, **caractérisé en ce que** la première paroi latérale et/ou la deuxième paroi latérale de la cavité présente une forme spatialement incurvée et/ou des zones s'écartant spatialement d'un plan.

13. Procédé selon la revendication 12, **caractérisé en ce que** le film de matière plastique (1) est un film de matière plastique matricé dont la forme est adaptée à celle de la première paroi latérale.

14. Capteur de contact capacitif comportant une plaque de support constituée de matière plastique, permettant de déclencher une opération de commutation par contact avec sa surface frontale et sur la surface arrière de laquelle sont disposées une ou plusieurs électrodes de capteur capacitives qui sont reliées par des pistes conductrices à une électronique d'évaluation, dans lequel les zones disposées en face des électrodes de capteur sur la surface frontale de la plaque de support forment des zones de contact, **caractérisé en ce qu'**un film de matière plastique (1) porte sur l'une de ses faces les électrodes de capteur et des pistes conductrices et la plaque de support (4, 4', 4", 4'", 4"") constituée de polycarbonate ou de polyméthacrylate de méthyle est moulée par injection sur son autre face, dans lequel un revêtement (3) résistant aux rayures est moulé par injection sur la face de la plaque de support (4, 4', 4", 4"', 4"") qui est opposée au film de matière plastique (1), revêtement dont le matériau réagit avec le polycarbonate ou se lie par complémentarité de matériau au polyméthacrylate de méthyle de la plaque de support.

15. Capteur de contact capacitif selon la revendication 14, **caractérisé en ce que** le film de matière plastique (1) est constitué de polycarbonate.

16. Capteur de contact capacitif selon l'une quelconque des revendications 14 ou 15, **caractérisé en ce que** le revêtement (3) résistant aux rayures est constitué d'un polyméthacrylate de méthyle (PMMA).

17. Capteur de contact capacitif selon l'une quelconque des revendications 14 à 16, **caractérisé en ce que** le revêtement (3) résistant aux rayures présente une structure de surface sur la face de la plaque de support (4"') qui est opposée au film de matière plastique (1).

18. Capteur de contact capacitif selon l'une quelconque des revendications 14 à 17, **caractérisé en ce que** la face de la plaque de support qui est opposée au film de matière plastique (1) présente une ou plusieurs protubérances (10, 11) et/ou un ou plusieurs renfoncements (8).

19. Capteur de contact capacitif selon l'une quelconque des revendications 14 à 18, **caractérisé en ce qu'**une électronique d'évaluation est disposée sur la face du film de matière plastique qui porte les électrodes de capteur et les pistes conductrices.
